# EUROPEAN PATENT APPLICATION

(11) **EP 1 788 708 A1**
(43) Date of publication of application: **23.05.2007**
(21) Application number: 05025053.9
(22) Date of filing: 16.11.2005
(51) Int. Cl.: H03M 13/15, H03M 13/47

(54) **Method and device for decoding encoded symbols**

(71) Applicant: BenQ Corporation, Gueishan Taoyuan 333 (TW)
(72) Inventor: The designation of the inventor has not yet been filed
(74) Representative: Epping - Hermann - Fischer

(57) **Abstract**

A method and a device for decoding encoded symbols is provided wherein coded symbols are generated with the use of a generator matrix of a block code. The coded symbols comprise a number of subsymbols wherein the coded symbols are transmitted to a receiver and at least one coded symbol comprises a corrupt subsymbol. During the decoding process the coded symbols corresponding to rows of a decoding matrix are rearranged, so that all symbol rows of the data matrix with no corrupt subsymbols are placed first. Then a Gaussian elimination on the decoding matrix for each row of the corresponding symbol rows with no corrupt subsymbols is performed. Then a symbol row with at least one corrupt subsymbol in the data matrix and no corresponding zero row in the decoding matrix is selected. On the remaining rows of the decoding matrix a maximum Gaussian elimination is applied. This procedure is repeated until the rank of the decoding matrix is full. Then the at least one corrupt subsymbol can be recovered.

## Description

The present invention relates to a method for decoding coded subsymbols. The invention further refers to a device for decoding coded subsymbols.

During transmission of data packets, for example for audio or video applications from a transmitter to a receiver, transmission errors may occur due to interference or disturbances on the transmission channel. Such interference will result in loss of data packets on the receiver side. For example for multimedia broadcast/multicast services (MBMS) within the 3GPP standard, data packets are transmitted by a transmitter to a plurality of receivers. Because of interference on the transmission channel different receivers may receive different corrupt data packets. However, especially for multimedia services, it might be necessary to reconstruct all data packets in order to ensure reception of an error-free data stream.

One possibility to fulfill this requirement is to individually request the lost packets by means of an automatic repeat request (ARQ) mechanism. While for a single receiver the ARQ mechanism may guarantee reliable transmission, this procedure will not be appropriate for broadcast services, since for example, a feedback channel may not be available or if available, there is the danger of a possible feedback implosion.

The different lost data packets result in different losses of the data for each receiver.

Therefore, forward error correction (FEC) codes are employed to compensate for or correct the channel disturbance. Such forward error correction adds redundancy to the data to be transmitted and inserts additional parity data derived from the data packets to be transmitted. The parity data is also transmitted and can be used by the receiver to correct corrupt data packets.

The use of forward error correction code increases the overall performance and significantly reduces data errors or lost data packets. Generally, the benefits of a FEC codes will be higher, if the code is applied closer to the physical transmission layer of a protocol stack. However, on real systems forward error correction is often used in upper layers, mainly in the upper protocol layers since the upper layers are usually implemented in software and thus can easily be upgraded.

Generally a data packet or a packet with parity data consists of one or more symbols. The data packet comprises one or more source symbols, and a parity packet comprises of one or more parity symbols. Depending on the FEC code used for encoding the symbols, a usually complex decoding procedure has to be applied, resulting in a high computational effort.

Therefore, it is in general desirable to provide a method and a device for decoding of coded symbols with low computational efforts.

According to the invention, a method and a device are provided in accordance to the independent claims 1 and 9 respectively. Various embodiments of the invention are subject matter of the dependent claims.

According to the present invention, the total number of the computationally intensive decoding steps is reduced by computing common information together. This procedure allows using the already computed information in the next decoding attempts.

According to the present invention, a plurality of coded symbols of a specific length can be generated for example with the use of a generator matrix of a block code. The coded symbols comprise a number of coded subsymbols, wherein the coded symbols are being transmitted to a receiver. During transmission a transmission error may occur resulting in the loss of at least one subsymbol, but usually several or sub-symbols might be lost. For decoding the information, the received coded symbols are arranged in a data matrix and a decoding matrix is generated based on the received subsymbols which is derived from the generator matrix. The lost subsymbols can be reconstructed by rearranging the data matrix and the decoding matrix. Particularly, the reconstruction is performed within the data matrix on a plurality of subsymbols in different columns and different rows rather than on each of the subsymbol columns, so that a transmission error and loss of subsymbols respectively can be eliminated and the original data can be recovered.

In an embodiment of the present invention, the block code used for encoding the source symbols is a non-systematic block code. In another embodiment, the block code is a systematic block code. For example, a systematic or non-systematic Raptor code can be used as the block code for the encoding process of the source symbols to be transmitted. Alternately an LDGM or LDPC code can be used as well. More generally, any block code can be used, which is representable by a binary encoding matrix, of which the decoding matrix can be derived. So for example the subsymbols must be representable by a binary encoding matrix whereby the encoding symbols can either be jointly encoded or encoded sub-symbol by sub-symbol whereby the resulting encoded symbols from both procedures are the same.

The invention can be used in a permeable-layer receiver environment, which makes use of partial symbols available at the receiver whereby partial symbols consist of one or several subsymbols. An example how these subsymbols are available might be a permeable-layer receiver which allows passing partly correct packets to upper layers. More particularly, the partly correct information might represent parts of coded symbols, i.e. correct subsymbols. Correct subsymbols require that the coded symbol position the subsymbol belongs to as well as the subsymbol position within the symbol.

The invention will be explained in more detail in the following description referring to a number of exemplary embodiments and with reference to the drawings, in which:
- Figure 1A: shows a download delivery protocol stack, in which the invention can be used;
- Figure 1B: shows a general block diagram of transmission process
- Figure 2: shows an example of a plurality of packets received with a permeable layer receiver;
- Figure 3: shows method steps of a first embodiment of the present invention for decoding block-coded symbols;
- Figures 4A to 4I: show an example of a data matrix in different decoding states and
- Figure 5: shows an embodiment of a device for receiving a modulated signal and decoding block-coded symbols out of the signal.

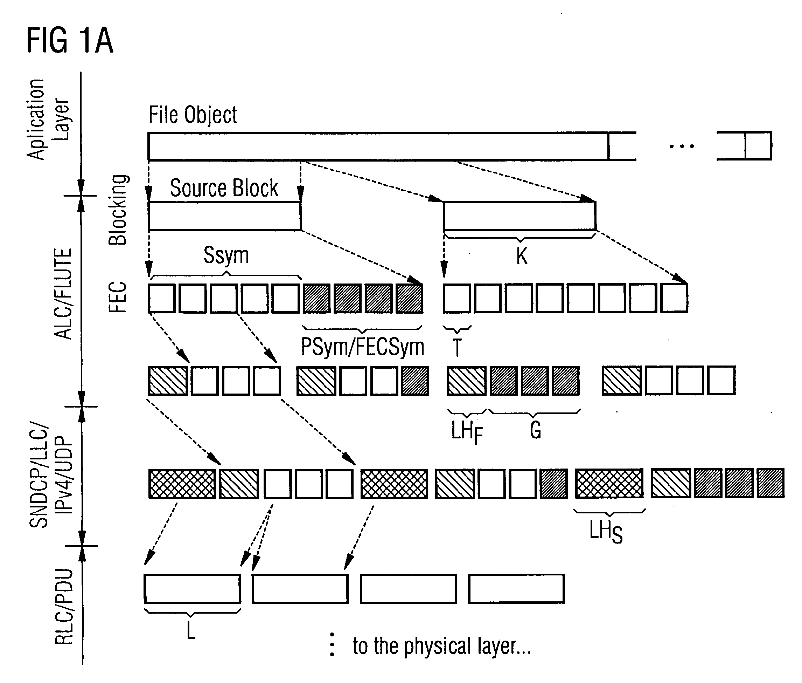

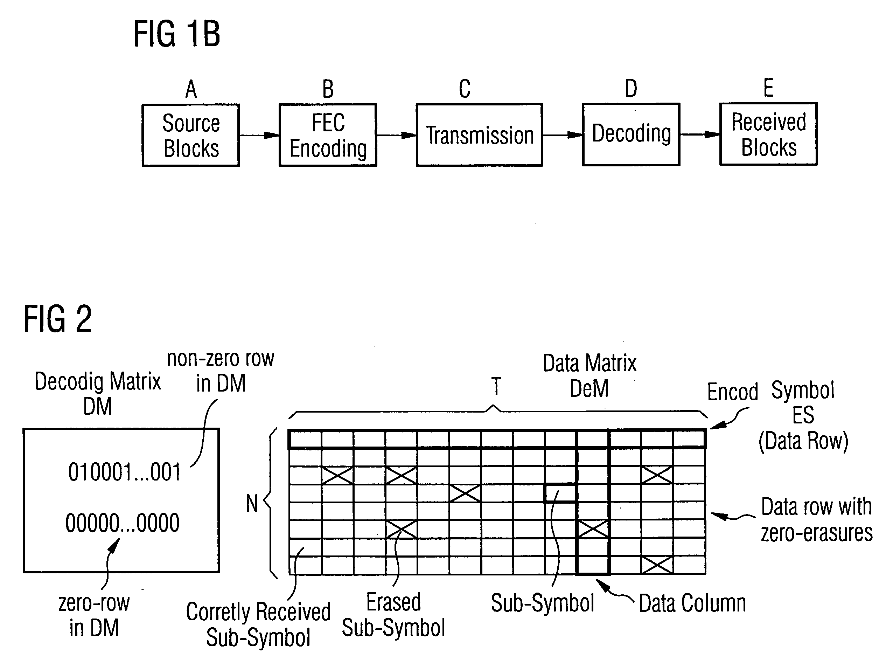

Figure 1 shows an example of a multilayer protocol stack for MBMS download delivery. An application layer comprises an object of a certain data size, which, for example, may be represent a file. The file shall be transmitted to a receiver. The file itself is partitioned into N_{B} source blocks, for example by splitting the file such that each source block comprises a length of K symbols and each symbol comprises of T subsymbols.

At this point a forward error correction is applied to each of the source blocks. Each source block is individually encoded by a block code which can for example be represented by a generator matrix G. In this non-limiting example a systematic or non-systematic block code, for example an Raptor code is used. A source block number (SBN) and an encoded symbol identifier (ESI) are associated with each encoded symbol S_{sym} of the source block. After the generation of the source symbols and the repair or FEC symbols, a packet is constructed by collecting a number G of encoded symbols into a packet. The payload P of each packet is given by P = G x T. The packet is then transported to the physical layer and transmitted to the receiver.

Figure 1B shows a very general block diagram, not restricted to any protocol. The data or file to be transmitted is assumed to be split into different source blocks. Each of the source blocks comprises one or more encoding symbols of a specific length. The encoding symbols themselves can be split into different subsymbols.

The forward error correction code can either be applied onto the encoding symbols or on the subsymbols. This means that the encoding symbols can either be jointly encoded or encoded sub-symbol by sub-symbol whereby the resulting block encoded symbols from both procedures are the same. The FEC code computes N encoded symbols from each source block, whereby each coded symbol contains T coded subsymbols. A subsymbol can range from one bit to a group of bits up to some bytes. The FEC code itself in this example is represented by a binary encoding matrix. For example a Raptor code can be used. Alternately a LDGM or a LDPC code is for example applicable.

The coded symbols are transmitted through a channel C. The channel C comprises a transmitter, which transmits the coded symbols to a receiver via a signal. The receiver receives the signal and derives block coded symbols ES from the signal. Each coded symbol comprises an identifier. The total output of the channel C are subsymbols, whereby a subsymbol is either received correctly or it is erased due to errors during transmission. Due to the identifier, one can identify each subsymbol and determine to which encoded symbol of which Source Block does it belong to. The channel output is sent to the decoding stage, on which the decoding process is applied. The output is the reconstructed received source blocks.

Figure 2 shows an example of a decoding block for a download delivery with N = 8 transmitted encoded symbols ES having T=14 subsymbols each in a data matrix DaM. In the data matrix, the received symbols from the output of channel C are stored, whereby each row of the data matrix corresponds to an encoded symbol ES. In addition a decoding matrix DM is obtained. The decoding matrix DM is obtained from the encoding matrix of the FEC code in block B. However, only the rows of the decoding matrix corresponding to rows of the data matrix, which have at least one received subsymbol are present. In some documents by the standardization groups, the encoded symbol ES is also referred to as an "encoding" symbol.

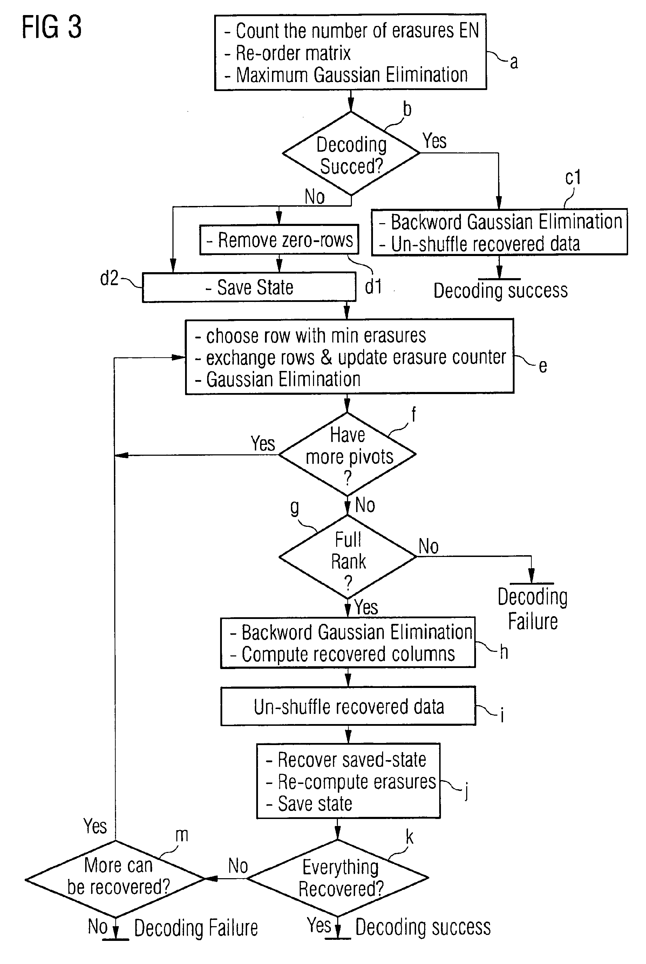

In a conventional receiver these corrupt packets will be lost and the receiver may fail to recover the complete source block. In a permeable layer receiver, the packets containing intact encoded symbols are used for recovery. Due to the fact that subsymbols will be marked as erased in symbols decoding algorithm are possible that effectively reduce the number of computations required for decoding. An exemplary embodiment of such a method according to the present invention is shown in Figure 3.

The method uses the decoding matrix DM, representing the code constraints given by the received encoded symbol identifiers ESI. The N x T data matrix DaM as seen in Figure 2 contains the received information of all at least partly received symbols. The data matrix includes symbols with correctly received subsymbols while corrupt subsymbols are marked as erased. The positions of corrupt subsymbols are marked by specific erasure markers. An erasure counter may be defined for each row in which the number of lost subsymbols in each row is stored.

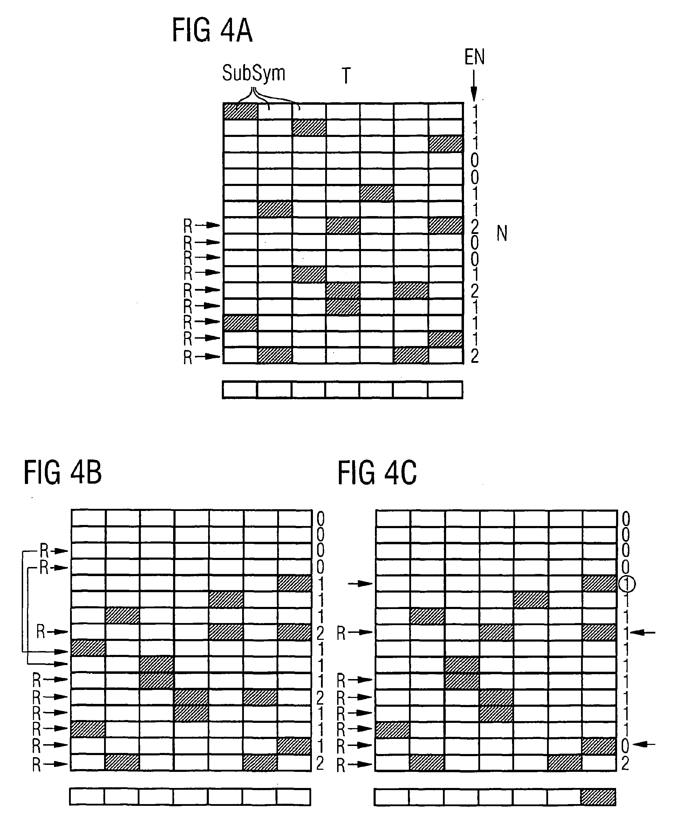

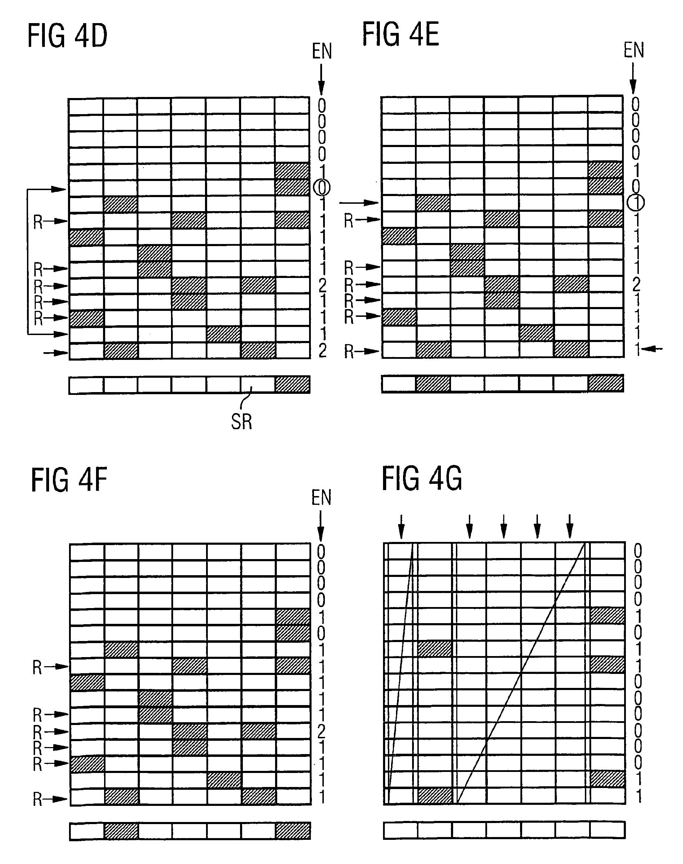

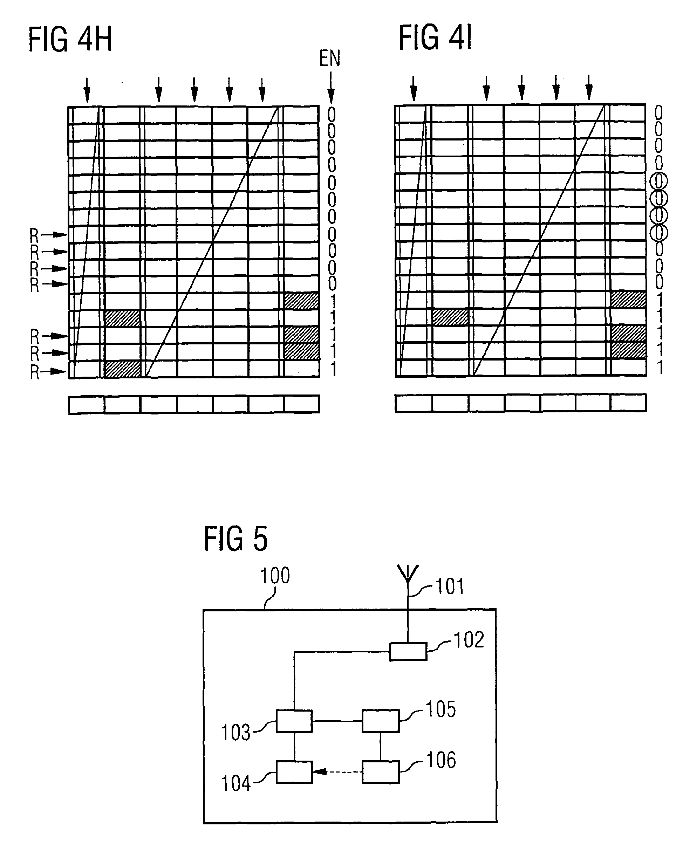

The decoding matrix DM is for example generated from a known generator matrix used for encoding the symbols. The German patent applications DE 10 2005 020 925.4 and DE 10 2005 021 321.9, which are incorporated herein by reference disclose the generation of a coding matrix CM used to generate the FEC symbols from the source symbols. This generation is appropriate when using more than just one systematic or non-systematic block code. Figures 4 and 6 and the description of DE 10 2005 020 925.4 on pages 15 to 20 of the application as filed show two examples of the generator matrices. Furthermore, the DE 10 2005 020 925.4 and DE 10 2005 021 321.9 disclose the generation process of the decoding matrix from the generator matrix. A detailed example is given in Figures 1 and 2 of DE 10 2005 021 321.9 and the corresponding description on pages 3 to 10.

The method for decoding can be divided into three main phases. In the first phase in step a, the number of erased subsymbols is counted first and saved in an erasure counter array EN. Further, a decoding matrix column number DMCN is generated. The DMCN comprises an array with as many numbers as the number of columns in the DM, whereby each number uniquely identifies a column in the DM. Then the decoding matrix as well as the data matrix are reordered such that rows with zero erasures (no lost subsymbols) are merged together. For example, the data matrix Dam and the decoding matrix DM are reordered such that rows with zero erasures in the data matrix are moved up and appear first. The corresponding rows in the decoding matrix are moved as well. The reordered matrix will then show only the symbols with valid and correct subsymbols in the first row.

After this reordering, a maximum Gaussian elimination procedure is applied on the rows of the decoding matrix DM corresponding to rows of the data matrix DaM with zero erased sub-symbols. The term "maximum Gaussian elimination" refers to a forward step of a standard *Gauss-Jordan Elimination* with Full-Pivoting. This procedure can be found in different textbooks and allows row exchanges, column exchanges, multiplication by scalar and row additions. If columns of the decoding matrix are exchanged, then one will have to update the DMCN.

During the maximum Gaussian elimination process, the diagonal in the decoding matrix is extended to its maximum. It is possible that the process leads to a fully decoded source block. In this case, method checks for a full decoding in step b and will proceed to step c1. In step c1 a backward Gaussian Elimination is applied to bring the decoding matrix DM into the *Unitary Matrix Form*, whereby the decoding matrix is filled with '0's, except that it has '1's only in the main diagonal. This procedure uses row additions and multiplications of rows by scalars.
The recovered data is the un-shuffled and reordered using information of a saved state of the data Matrix and the decoding matrix and the decoding matrix column number DMCN.

If the decoding process in step b is not successful, then the method continues in step d1 and d2. In step d1, all rows in the decoding matrix having only zeros and the corresponding data rows in the data matrix are removed. Thus, the dimension of the decoding matrix is reduced. Since zero rows in the decoding matrix are not necessary for the further decoding process and will therefore not be used, the step d2 is optional. Another possibility is to move these rows to the bottom of the decoding matrix and ignore them in the future steps of the algorithm. Then the state of the data matrix DaM, the decoding matrix DM and the erasure number En is saved in step d2 by copying the matrices and the erasure number to a buffer.

From this point on, the basic idea is to add rows in a greedy manner to the decoding process which allows recovering a maximum amount of data until decoding of partly data is accomplished. Henceforth, the method according to the present invention will start an iteration process including the steps e and f. Other methods which do not add rows for maximum amount in a greedy manner, but add rows with some other criteria might be thought of.

In the step e, a row with a minimum number of corrupt subsymbols or erasures respectively is selected. Furthermore, it is reasonable to select rows where the corresponding row of the decoding matrix DM has a non-zero weight. The selected row is shifted to the upper parts of the matrix and placed for example under the rows with zero erasures. Then the erasure counter EN is updated. More particularly, the rows of the data matrix DaM that are placed after the last selected row are scanned. The numbers of erased subsymbols which are not in a data matrix column that contains an erased subsymbol of any previously selected rows are counted. Finally in step e, a maximum Gaussian elimination procedure is applied. A column exchange is applied as well if necessary.

In step f it is checked whether the process of step e can be repeated. This is the case, if at least one selectable row in the decoding matrix comprises a "1". The decoding matrix is then considered to have more pivots. Otherwise the method will continue with step g.

If the rank of the decoding matrix determined in step g does not show a full rank, meaning there is no more pivots, in the decoding matrix available, the method will terminate the decoding process and return "a decoding failure".

If the decoding matrix does show a full rank, then the process will continue by applying a backward Gaussian elimination procedure in step h. The recovered columns are computed. The term refers to keeping the data structure of the recovered columns, whereby there are T entries in the recovered columns, whereby each entry specifies if a previously selected column contains an erasure. In step i the recovered data are un-shuffled, re-ordering only the columns which correspond to recovered columns. The column indexes used for the re-ordering process are given by DMCN.

In step j the saved state of method step d2 is recovered. The erased subsymbols in each symbol are recomputed in such a way that it is determined in the recovered save state matrix which columns have been fully recovered. The number of erased sub-symbols per row is re-computed, wherein the erased sub-symbols that fall into a previously recovered data column are not accounted for. Finally, the state is saved as in step d2.

As one can see, the steps e to j will be repeated until all data columns are considered to be recovered in step k or until no more recovery is possible as checked in step m. In the latter case, the method will signal forward a message and terminate. On the other hand, if all data columns are recovered then the output data is reordered depending on the row and column exchanges applied during the method execution. Recovering in step m will be possible, if there is at least one data column with at least one non-erased subsymbol that is not part of an already recovered data column.

The following pseudo code below shows another embodiment of the present invention. The code represents the method to recover lost subsymbols in a data matrix comprising N received symbols.

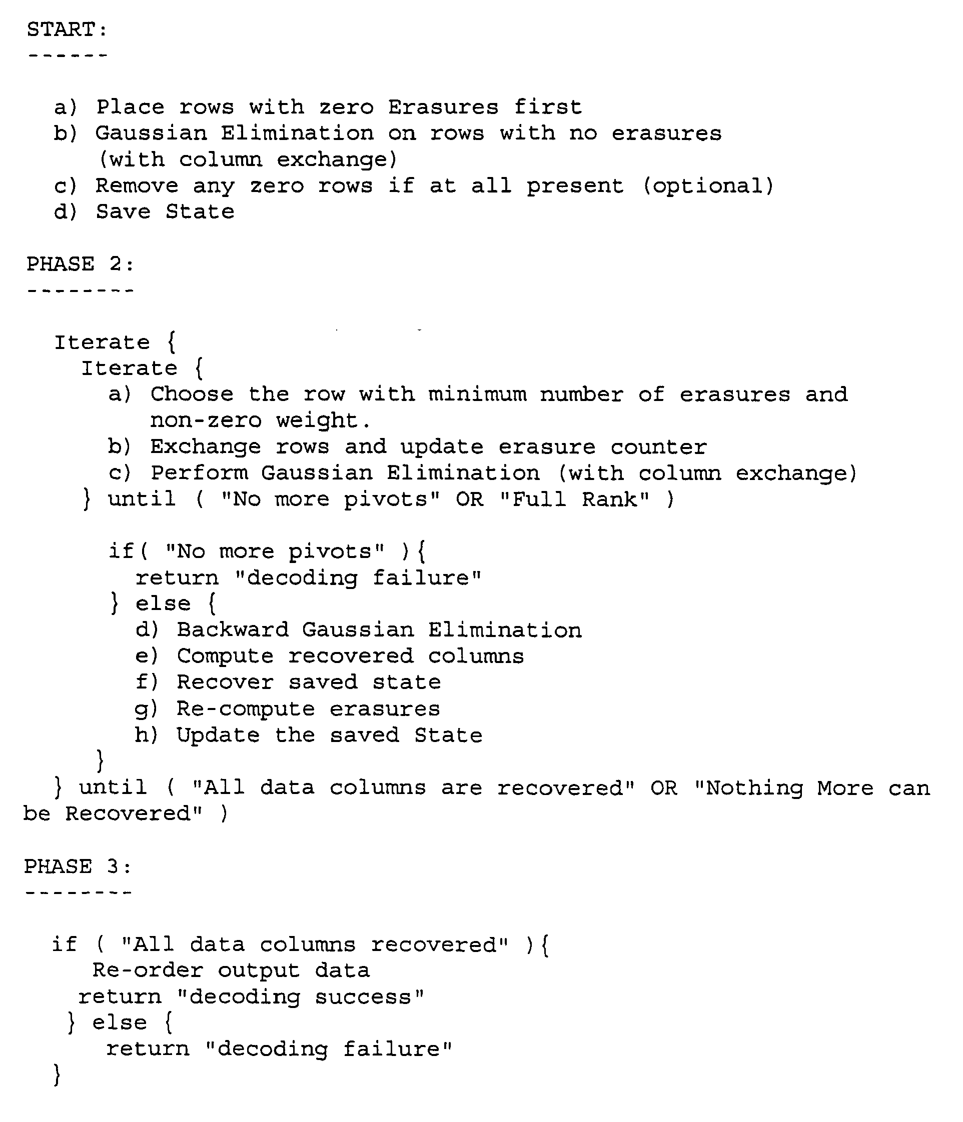

Figures 4A to 4H show the different states of a data matrix of N = 16 received symbols of length T = 7 during the decoding process according to the present invention. The numbers EN on the right hand side of the matrix correspond to the number of lost subsymbols in a given row. These numbers are stored in an erasure counter coupled to each of the rows of the data matrix. The additional row represents an intermediate information storage SR used by the method to store some information for later use. Figure 4A shows the initial set-up of the data matrix. The matrix T x N shown herein can be inverted if the rank of the matrix is full, i.e. Rg (T x N) = T.

In the first step according to Figure 4B all rows with no corrupt subsymbols are shifted to the upper part of the decoding matrix, which is not shown here. The corresponding rows of the data matrix are shifted as well. In this case, the third and fourth rows are exchanged with the ninth and tenth row respectively. Then, according to the present invention, a maximum Gaussian elimination is applied to the first four rows of the decoding matrix.

In Figure 4C the iteration is started by selecting a row with a minimum number of lost subsymbols. This can be done in various ways. For example, a row with a minimum number of lost subsymbols is selected randomly. Alternately a row with a minimum number of lost subsymbols is sequentially selected or, more specifically, selected starting from the first row with erased subsymbols or starting from the last row of the data matrix. Yet another possibility is, for example, to apply a search algorithm that determines the maximum number of common lost subsymbols in corresponding columns. In the present case, for example, in the last column in different rows three subsymbols are marked as erased and lost. Since no other column includes the same amount or even more lost sub-symbols, it is useful to select a row with a lost subsymbol in the last column. Hence, the fifth row is selected first as indicated by the arrows on the left side. This choosing will reduce the number of iteration steps for the total decoding process thereby reducing the total amount of time and power used to recover all data.

After selection of a row, a maximum Gaussian elimination procedure is applied with the fifth row on the remaining rows of the decoding matrix.

In Figure 4D, the sixth row is exchanged with the fifteenth row. As one can see, the sixth and eighth rows both include a lost subsymbol in the last column. All other subsymbols in the rows are valid. Henceforth, the lost subsymbol in the lost column of the sixth and eighth row can be marked as an erased data block in which the erasure is common in the same column as an erasure of the selected row. The erasure counter EN is updated accordingly. The lost subsymbol in the last column is also stored in the last column of the storage row SR. Then the sixth row with an erasure counter of zero is selected and a Gaussian elimination is applied thereon.

In Figure 4E, the seventh row with a lost subsymbol on the second column is selected and a maximum Gaussian elimination is applied on the remaining rows. After processing of the seventh row with its second lost subsymbol the erasure counter is updated again. Due to the pre-processing of its subsymbol in the second column, the erasure counter of the last row is reduced by one.

After processing of the seventh row, the corresponding decoding matrix does show full rank. In Figure 4F shows the state of the data matrix can be seen. Now the steps d1 to h of the method according to the present invention are executed and the partial symbol information is recovered. This is done by inverting the decoding matrix and applying a backward Gaussian elimination. The processing of the first seven rows now provides the matrix with valid and corrected subsymbols. After the inversion of the decoding matrix, the recovered sub-symbol columns are taken into consideration and the matrix as shown in Figure 4C is recovered. The result is shown in Figure 4G. The first and third to sixth columns are reconstructed and they contain no lost subsymbols anymore. As seen in Figure 4H, the matrix is reordered again by shifting zeros with no lost subsymbols in the upper part of the matrix. Then in steps 4I some of the rows with newly recovered subsymbols are selected and Gaussian elimination is applied. The steps are repeated until the maximum rank of the matrix has once again been reached.

After a second inversion and backward Gaussian elimination of the matrix, after recovering the lost subsymbols, computing the recovered columns and updating the saved state, all sub-symbols in the columns are recovered.

In this example, only two matrix inversions and backward Gaussian eliminations have to be applied while in a conventional decoder an inversion is required for each of the columns of the data matrix.

The method according to the present invention allows reducing the complexity during decoding received symbols. This will result in a performance gain and a reduction of processing time and power consumption.

A further embodiment of the present invention can be seen with reference to the Tables at the end of the description.

Table 1 shows a decoding matrix DM and a received data matrix including fourteen symbols with six subsymbols each. Some of those subsymbols marked as "X" are considered to include corrupt or erased data. They are marked as erased. Next to the data matrix the erasure counter number EN is defined, which includes the number of erased subsymbols per symbol row.

In the first step all rows of Table 2 in the data matrix with a corresponding erasure counter EN = 0 are exchanged and shifted to the upper part of the data matrix. As one can see, the corresponding rows of the decoding matrix are shifted as well.

Then a maximum Gaussian elimination procedure including column exchange is applied on the decoding matrix as seen in Table 3. The Gaussian elimination perform different linear operations on the matrix without changing the rank of the matrix. These operations include:
- changing two rows or columns with each other;
- multiplying a row with a scalar;
- add or subtract a multiple of one row to a second row.

The linear operations will zero all not independent rows, and leave only rows that are independent of each other. The pivots are extended to their maximum limit in the diagonal of the decoding matrix. After the elimination, the state of the decoding matrix and the data matrix is saved. Table 3 shows the decoding matrix and the data matrix just before the first iteration of phase 2.

The separation of the last two columns and the decoding matrix is used to visualize the following procedures. As one can see, the lower left part of the decoding matrix is already an all zero matrix due to the maximum Gaussian elimination process. In step d1 according to the present invention a row with a minimum number of lost subsymbols is selected. This procedure is shown in Table 4.

In this case the row is selected randomly. The corresponding row of the decoding matrix DM is not an all zero row. After the selection of the tenth row, the row is exchanged and shifted to the upper part as shown in Table 5. The remaining rows with subsymbols marked as erased are shifted down. This procedure will allow continuing the maximum Gaussian elimination procedure later on. Furthermore, the rows 9 and 14 which also include a lost subsymbol on its first column are preprocessed. The lost subsymbols in those rows are now covered by the lost subsymbol of the selected row. When updating the erasure counter, all rows that have a common number of erasures with the selected row are now marked as having fewer erasures. The erasure counter EN for the rows 9, 14 is now reduced to one.

After updating the erasure counter a maximum Gaussian elimination process including a column exchange is applied. Furthermore, the last column is exchanged with the seventh column to move the pilot to the diagonal. Then linear row additions are applied to eliminate the "1" in the other rows of the decoding matrix DM. This procedure is repeated by choosing another row with a minimum number of lost subsymbols. The result is shown in Table 6.

The rows of the data matrix in which the rows of the corresponding decoding matrix is an all zero row cannot and will not be selected since there is no available pivot. An all zero row is marked in Table 7 with an "!". Then a new row with a minimum number of erased subsymbols is selected. The 13^{th} row is selected, because the other data rows with just one lost subsymbols correspond to an all zero row in the decoding matrix DM. The 13^{th} row is shifted to the upper part. In addition the erasure counter is also updated. The result is shown in Table 8.

Once again a maximum Gaussian elimination with a column exchange is applied. In this case the pivot has reached the right side of the matrix and all the lower rows are marked as being all zero rows.

The decoding matrix DM now has a full rank. A full rank of the matrix allows inverting the decoding matrix and to perform a standard backward Gaussian elimination step. The results of the backward step can be seen in the following Table 10.

Then the recovered columns can be computed. The recovered columns correspond to those columns in the data matrix where no lost subsymbol occurs and no erasure happens. As shown in Table 11, the four middle columns of the data matrix can be recovered because no lost subsymbol is present in the data part. The remaining rows are not used in the Gaussian elimination and therefore do not count for determining the recovered columns. The symbols R in the columns shown in Table 12 represent the data that has been recovered in this iteration of the method. The number of lost subsymbols in each row has to be recounted, considering the already recovered columns. As one can see, the number of lost subsymbols is reduced dramatically.

For starting with a second iteration, it is possible to start again by shifting all rows with no lost subsymbols to the upper part of the matrix and applying a maximum Gaussian elimination procedure. However, this is not required because in step e a row with a minimum number of lost subsymbols is selected. This is similar to the procedure of reordering the matrix in step a.

As seen in Table 13 the 11^{th} row with no lost subsymbols is selected. In Table 14 the selected row is shifted to the upper part of the decoding matrix and the data matrix. Then the erasure counter EN is updated. Since, in this case the erasure counter of the selected row is zero, it is not necessary to update any other erasure counters. Then, again a maximum Gaussian elimination is applied. The results can be seen in Table 15. As one can see, the decoding matrix DM now includes all zero rows which are not be selected when choosing a row with a minimum number of lost subsymbols.

Row number 10 is selected and exchanged. The erasure counter EN is updated and the maximum Gaussian elimination including a column exchange is applied. The results can be seen in Tables 16, and 17.

Now again the maximum rank of the decoding matrix is reached and the method continues with step d by applying a backward Gaussian elimination on the matrix. The recovered columns are computed as can be seen in Table 18. Again the recovered columns are recomputed as shown in Table 19. The Table 20 shows the situation before the third iteration of phase 2 of the method according to the present invention. All except the last column of the data matrix are fully recovered. In the attempt to recover the final column one initiates a repetition again by selecting the 11^{th} row, shifting the row, and applying the maximum Gaussian elimination. Table 21 shows the result.

After selecting the 10^{th} row, shifting and applying the MGE again, the decoding matrix has full rank and the restoring procedure can be initiated. The present invention can be used for systematic or non-systematic block codes. The erasure counter can be a number as seen in the various embodiments of the present invention or any other indicator. It is appropriate to use a permeable layer receiver in order to process partly valid information and recover the complete symbol using the present decoding method.

Figure 5 shows an end user device 100 capable of decoding block-coded symbols. The receiver comprises a receiving element 101 receiving a signal transmitted by a transmitter. The received signal is forwarded to a demodulator 102. The demodulator demodulates the signal and extracts the data stream out of it. The demodulator is coupled with its output to an element 103, which combines the demodulated data into packets and analyzes the received symbols and data packets. For example, the element 103 is adapted to analyze the UDP checksum. If the checksum is correct, the packet shall be forwarded to an upper layer element 104 for an appropriate action in the decoding procedure.

If the checksum is not correct, the packet is sent to elements 105, where it is checked for any sequence of zero bytes. All parts of the UDP payload for which those properties hold are declared as erased or corrupt. If one of the headers in the packet is in the erased part, the total packet is dropped. Otherwise correct symbols for the FEC decoding process are extracted. Henceforth, the element 106 is coupled to an FEC-decoder adapted to perform the decoding process according to the present invention. The processed and decoded packets are then forwarded to element 104 for further processing. If a packet cannot be fully recovered, the device will send a request to the transmitter, requesting the lost and non-recoverable packet again.

The method and the device can be used for mobile communication standard like for example 3GPP, 802.11, WLAN, Bluetooth and so on. It is also usable for other communication standard like for example TV standards like DVB-H, DVB-T, DVB-S, wherein a single transmitter transmits data to a plurality of receivers.

**Table 1:**

| Decoding Matrix DM | Data Matrix | EN |
|---|---|---|
| 10001001 | - - -XXX | 3 |
| 01010010 | XX- - - - - | 2 |
| 10101011 | - - - - - - | 0 |
| 11101001 | - - - - - - | 0 |
| 00100001 | - -XXXX | 4 |
| 00000100 | X- - - - | 1 |
| 00100011 | - - - XX- | 2 |
| 00101001 | - - - - - - | 0 |
| 00010001 | - - - - - - | 0 |
| 01001000 | - -XX- - | 2 |
| 11100010 | - - - - - -X | 1 |
| 00010101 | XX- - - - | 2 |
| 01010101 | - - - - - - | 0 |
| 01111101 | - - - - - - | 0 |

**Table 2**

| Decoding Matrix | Data Matrix | EN |
|---|---|---|
| 10101011 | - - - - - - | 0 |
| 11101001 | - - - - - - | 0 |
| 00101001 | - - - - - | 0 |
| 00010001 | - - - - - | 0 |
| 01010101 | - - - - - - | 0 |
| 01111101 | - - - - - - | 0 |
| 10001001 | - - - XXX | 3 |
| 01010010 | XX- - - - | 2 |
| 00100001 | - -XXXX | 4 |
| 00000100 | X- - - - - | 1 |
| 00100011 | - - - XX- | 2 |
| 01001000 | - - XX- - | 2 |
| 11100010 | - - - - - -X | 1 |
| 00010101 | XX- - - - | 2 |

**Table 3**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | - - -XXX | 3 |
| 000000 | 00 | XX- - - - | 2 |
| 000000 | 10 | - -XXXX | 4 |
| 000000 | 01 | X- - - - | 1 |
| 000000 | 11 | - - -XX- | 2 |
| 000000 | 11 | - -XX- - | 2 |
| 000000 | 11 | - - - - -X | 1 |
| 000000 | 01 | XX- - - - | 2 |

**Table 4**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - | 0 |
| 000001 | 00 | - - - - - - | 0 |
| 000000 | 11 | - - -XXX | 3 |
| 000000 | 00 | XX- - - - | 2! |
| 000000 | 10 | - -XXXX | 4 |
| 000000 | 01 | X- - - - | 1 ← |
| 000000 | 11 | - - -XX- | 2 |
| 000000 | 11 | - -XX- - | 2 |
| 000000 | 11 | - - - -X | 1 |
| 000000 | 01 | XX- - - - | 2 |

**Table 5**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 01 | X- - - - - | 1 |
| 000000 | 11 | - - --XXX | 3 |
| 000000 | 00 | xX- - - - | 1! = 2 - 1 |
| 000000 | 10 | - -XXXX | 4 |
| 000000 | 11 | - - - XX- | 2 |
| 000000 | 11 | - -XX- - | 2 |
| 000000 | 11 | - - - - -X | 1 |
| 000000 | 01 | xX- - - - | 1 = 2 - 1 |

**Table 6**

| Decoding | Matrix | Data Matrix | EN |
|---|---|---|---|
| 101001 | 11 | - - - - - - | 0 |
| 010000 | 10 | - - - - - - | 0 |
| 001001 | 01 | - - - - - - | 0 |
| 000101 | 00 | - - - - - - | 0 |
| 000010 | 10 | - - - - - - | 0 |
| 000001 | 00 | - - - - - - | 0 |
| 000000 | 10 | X- - - - - | 1 |
| 000000 | 01 | - - -XXX | 3 |
| 000000 | 00 | xX- - - - | 1! |
| 000000 | 01 | - -XXXX | 4 |
| 000000 | 01 | - - -XX- | 2 |
| 000000 | 01 | - -XX- - | 2 |
| 000000 | 01 | - - - - -X | 1 |
| 000000 | 00 | xX- - - - | 1 |

**Table 7**

| Decoding | Matrix | Data Matrix | EN |
|---|---|---|---|
| 101001 | 11 | - - - - - - | 0 |
| 010000 | 10 | - - - - - - | 0 |
| 001001 | 01 | - - - - - - | 0 |
| 000101 | 00 | - - - - - - | 0 |
| 000010 | 10 | - - - - - - | 0 |
| 000001 | 00 | - - - - - - | 0 |
| 000000 | 10 | X- - - - - | 1 |
| 000000 | 01 | - -XXX | 3 |
| 000000 | 00 | xX- - - - | 1! |
| 000000 | 01 | - -XXXX | 4 |
| 000000 | 01 | - - -XX- | 2 |
| 000000 | 01 | - -XX- - | 2 |
| 000000 | 01 | - - - - -X | 1 ← |
| 000000 | 00 | xX- - - - | 1! |

**Table 8**

| Decoding | Matrix | Data Matrix | EN |
|---|---|---|---|
| 101001 | 11 | - - - - - - | 0 |
| 010000 | 10 | - - - - - - | 0 |
| 001001 | 01 | - - - - - - | 0 |
| 000101 | 00 | - - - - - - | 0 |
| 000010 | 10 | - - - - - - | 0 |
| 000001 | 00 | - - - - - - | 0 |
| 000000 | 10 | X- - - - - | 1 |
| 000000 | 01 | - - - - -X | 1 |
| 000000 | 01 | - - -XXx | 2 = 3 - 1 |
| 000000 | 00 | xX- - - - | 1! |
| 000000 | 01 | - -XXXx | 3 = 4 - 1 |
| 000000 | 01 | - - -XX- | 2 |
| 000000 | 01 | - -XX- - | 2 |
| 000000 | 00 | xX- - - - | 1! |

**Table 9**

| Decoding | Matrix | Data Matrix | EN |
|---|---|---|---|
| 101001 | 11 | - - - - - - | 0 |
| 010000 | 10 | - - - - - - | 0 |
| 001001 | 01 | - - - - - - | 0 |
| 000101 | 00 | - - - - - - | 0 |
| 000010 | 10 | - - - - - - | 0 |
| 000001 | 00 | - - - - - - | 0 |
| 000000 | 10 | X- - - - - | 1 |
| 000000 | 01 | - - - - -X | 1 |
| 000000 | 00 | - - -XXx | 2! |
| 000000 | 00 | xX- - - - | 1! |
| 000000 | 00 | - -XXXx | 3! |
| 000000 | 00 | - - -XX- | 2! |
| 000000 | 00 | - -XX- - | 2! |
| 000000 | 00 | xX- - - - | 1! |

**Table 10**

| Decoding | Matrix | Data Matrix | EN |
|---|---|---|---|
| 100000 | 00 | - - - - - - | 0 |
| 010000 | 00 | - - - - - - | 0 |
| 001000 | 00 | - - - - - - | 0 |
| 000100 | 00 | - - - - - - | 0 |
| 000010 | 10 | - - - - - - | 0 |
| 000001 | 00 | - - - - - - | 0 |
| 000000 | 10 | X- - - - - | 1 |
| 000000 | 01 | - - - - -X | 1 |
| 000000 | 00 | - - -XXx | 2! |
| 000000 | 00 | xX- - - - | 1! |
| 000000 | 00 | - -XXXx | 3! |
| 000000 | 00 | - - -XX- | 2! |
| 000000 | 00 | - -XX- - | 2! |
| 000000 | 00 | xX- - - - | 1! |

**Table 11**

| Decoding | Matrix | Data Matrix | EN |
|---|---|---|---|
| 100000 | 00 | - - - - - - | 0 |
| 010000 | 00 | - - - - - - | 0 |
| 001000 | 00 | - - - - - - | 0 |
| 000100 | 00 | - - - - - - | 0 |
| 000010 | 10 | - - - - - - | 0 |
| 000001 | 00 | - - - - - - | 0 |
| 000000 | 10 | X- - - - - | 1 -RRRR- |
| 000000 | 01 | - - - - -X | 1 |
| 000000 | 00 | - - -XXx | 2! |
| 000000 | 00 | xX- - - - | 1! |
| 000000 | 00 | - -XXXx | 3! |
| 000000 | 00 | - - -XX- | 2! |
| 000000 | 00 | - -XX- - | 2! |
| 000000 | 00 | xX- - - - | 1! |

**Table 12**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRRX | 1 |
| 000000 | 00 | XRRRR- | 1! |
| 000000 | 10 | -RRRRX | 1 |
| 000000 | 01 | XRRRR- | 1 |
| 000000 | 11 | -RRRR- | 0 |
| 000000 | 11 | -RRRR- | 0 |
| 000000 | 11 | -RRRRX | 1 |
| 000000 | 01 | XRRRR- | 1 |

**Table 13**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRRX | 1 |
| 000000 | 00 | XRRRR- | 1! |
| 000000 | 10 | -RRRRX | 1 |
| 000000 | 00 | XRRRR- | 1 |
| 000000 | 11 | -RRRR- | 0 ← |
| 000000 | 11 | -RRRR- | 0 |
| 000000 | 11 | -RRRRX | 1 |
| 000000 | 01 | XRRRR- | 1 |

**Table 14**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRR- | 0 |
| 000000 | 11 | -RRRRX | 1 |
| 000000 | 00 | XRRRR- | 1! |
| 000000 | 10 | -RRRRX | 1 |
| 000000 | 01 | XRRRR- | 1 |
| 000000 | 11 | -RRRR- | 0 |
| 000000 | 11 | -RRRRX | 1 |
| 000000 | 01 | XRRRR- | 1 |

**Table 15**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRR- | 0 |
| 000000 | 00 | -RRRRX | 1! |
| 000000 | 00 | XRRRR- | 1! |
| 000000 | 01 | -RRRRX | 1 |
| 000000 | 01 | XRRRR- | 1 |
| 000000 | 00 | -RRRR- | 0! |
| 000000 | 00 | -RRRRX | 1! |
| 000000 | 01 | XRRRR- | 1 |

**Table 16**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRR- | 0 |
| 000000 | 00 | -RRRRX | 1! |
| 000000 | 00 | XRRRR- | 1! |
| 000000 | 01 | -RRRRX | 1 ← |
| 000000 | 01 | XRRRR- | 1 |
| 000000 | 00 | -RRRR- | 0! |
| 000000 | 00 | -RRRRX | 1! |
| 000000 | 01 | XRRRR- | 1 |

**Table 17**

| Decoding | Matrix | Data Matrix | EN |
|---|---|---|---|
| 101001 | 11 | - - - - - - | 0 |
| 010000 | 01 | - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | -RRRR- | 0 |
| 000000 | 01 | -RRRRX | 1 |
| 000000 | 00 | -RRRRx | 0! |
| 000000 | 00 | XRRRR- | 1! |
| 000000 | 00 | XRRRR- | 1! |
| 000000 | 00 | -RRRR- | 0! |
| 000000 | 00 | -RRRRx | 0! |
| 000000 | 00 | XRRRR- | 1! |

**Table 18**

| Decoding | Matrix | Data Matrix | EN |
|---|---|---|---|
| 100000 | 00 | - - - - - - | 0 |
| 010000 | 00 | - - - - - - | 0 |
| 001000 | 00 | - - - - - - | 0 |
| 000100 | 00 | - - - - - - | 0 |
| 000010 | 00 | - - - - - - | 0 |
| 000001 | 00 | - - - - - - | 0 |
| 000000 | 10 | -RRRR- | 0 |
| 000000 | 01 | -RRRRX | 1 |
| 000000 | 00 | -RRRRx | 0! |
| 000000 | 00 | XRRRR- | 1! |
| 000000 | 00 | XRRRR- | 1! |
| 000000 | 00 | -RRRR- | 0! |
| 000000 | 00 | -RRRRx | 0! |
| 000000 | 00 | XRRRR- | 1! |

**Table 19**

| Decoding | Matrix | Data Matrix | EN |
|---|---|---|---|
| 100000 | 00 | - - - - - - | 0 |
| 010000 | 00 | - - - - - - | 0 |
| 001000 | 00 | - - - - - - | 0 |
| 000100 | 00 | - - - - - - | 0 |
| 000010 | 00 | - - - - - - | 0 |
| 000001 | 00 | - - - - - - | 0 |
| 000000 | 10 | -RRRR- | 0 |
| 000000 | 01 | -RRRRX | 1 Rrrrr- |
| 000000 | 00 | -RRRRx | 0! |
| 000000 | 00 | XRRRR- | 1! |
| 000000 | 00 | XRRRR- | 1! |
| 000000 | 00 | -RRRR- | 0! |
| 000000 | 00 | -RRRRx | 0! |
| 000000 | 00 | XRRRR- | 1! |

**Table 20**

| Decoding | Matrix | Data Matrix | EN |
|---|---|---|---|
| 101001 | 11 | - - - - - - | 0 |
| 010000 | 01 | - - - - - - | 0 |
| 001001 | 10 | - - - - - - | 0 |
| 000101 | 00 | - - - - - | 0 |
| 000010 | 01 | - - - - - | 0 |
| 000001 | 00 | - - - - - - | 0 |
| 000000 | 11 | RRRRRX | 1 |
| 000000 | 00 | RRRRR- | 1! |
| 000000 | 10 | RRRRRX | 1 |
| 000000 | 01 | RRRRR- | 0 |
| 000000 | 11 | RRRRR- | 0 |
| 000000 | 11 | RRRRR- | 0 |
| 000000 | 11 | RRRRRX | 1 |
| 000000 | 01 | RRRRR- | 0 |

**Table 21**

| Decoding | Matrix | Data Matrix | EN |
|---|---|---|---|
| 101001 | 11 | - - - - - - | 0 |
| 010000 | 01 | - - - - - | 0 |
| 001001 | 10 | - - - - - - | 0 |
| 000101 | 00 | - - - - - - | 0 |
| 000010 | 01 | - - - - - - | 0 |
| 000001 | 00 | - - - - - - | 0 |
| 000000 | 11 | RRRRR- | 0 |
| 000000 | 01 | RRRRRX | 1! |
| 000000 | 00 | RRRRR- | 1! |
| 000000 | 00 | RRRRRX | 1 |
| 000000 | 01 | RRRRR- | 0 |
| 000000 | 00 | RRRRR- | 0! |
| 000000 | 00 | RRRRRX | 1! |
| 000000 | 01 | RRRRR- | 0 |

## Claims

1. Method for decoding encoded symbols,
- said encoded symbols (ES) having been received by a receiver in response to a transmission process, wherein in said transmission process encoded symbols (Ssym, PSym, FECSym) are generated, applying a forward error correction block code,
- said encoded symbols comprising a number of subsymbols (SubSym) being generated with the same code constraints as the encoded symbols, and at least one encoded symbol of said encoded symbols (ES) comprising a transmission error in at least one of the subsymbols, said at least one subsymbol being marked as an erased subsymbol and,
- at the receiver a number of partly received encoded symbols are available such that a partly received encoded symbol comprises at least one correctly received subsymbol, wherein a position of said correctly received subsymbol with the partly received encoded symbol is known,
the method comprising the steps of:
- arranging said number of said partly received encoded symbols (ES) in a data matrix (DaM), having columns and symbol rows (N) corresponding to rows of a decoding matrix (DM), said decoding matrix (DM) derived from the generator matrix;
- rearranging the decoding matrix (DM) and the data matrix (DaM) to place all symbol rows (N) of the data matrix with (DaM) no erased subsymbols first;
- storing the number of erased subsymbols for each symbol where at least one subsymbol is marked as erased in the data matrix (DaM) in an erasure counter (EN) for each symbol row (N) ;
- saving the state of the data matrix (DaM) and the state of the decoding matrix (DM);
- selecting a first symbol row with at least one subsymbol marked as erased in the data matrix (DaM) and the corresponding row in the decoding matrix (DM) is not a row including only zeros;
- exchanging the selected first symbol row in the data matrix and the row in the decoding matrix (RM) with a row following the rows in the data matrix with no erased subsymbols;
- recalculating the erasure counter (EN) for each symbol row (N) of the data matrix;
- applying maximum Gaussian elimination on each of the rows of the decoding matrix (DM) corresponding to the remaining rows of the data matrix with the at least one subsymbol marked as erased;
- recovering the at least one erased subsymbol of the selected row and reconstructing the decoding matrix (DM) and the data matrix from the saved state.

2. The method of claim 1,
wherein the step of storing the number of the at least one subsymbol comprises the step of:
- applying a maximum Gaussian elimination on the decoding matrix (DM) until a given row whereby said given row corresponds to the last row of the data matrix containing no erased subsymbol.

3. The method of one of the claims 1 to 2,
wherein the block code comprises a non-systematic block code and wherein the decoding matrix (DM) is derived from the generator matrix (G) comprising the step of copying the generator matrix into the decoding matrix (DM).

4. The method of one of the claims 1 to 2,
wherein the block code comprises a systematic block code and
wherein the decoding matrix (DM) is derived from the generator matrix (G) comprising the step of copying the generator matrix into the decoding matrix (DM).

5. The method of one of the preceding claims,
wherein the block code comprises any binary erasure code representable by a binary encoding matrix.

6. The method of one of claims 1 to 5,
wherein during said transmission process coded symbols are generated by jointly encoding symbols or encoding symbols bit-by-bit.

7. The method of one of the preceding claims,
wherein the block code comprises a raptor code.

8. The method of one of the preceding claims,
wherein the step of saving the state of the data matrix (DaM) and the state of the decoding matrix (DM) comprise the steps of:
- applying maximum Gaussian elimination on each of the rows of the decoding matrix (DM) corresponding to the rows of the data matrix (DaM) with no erased subsymbol;
- reducing the dimension of the decoding matrix (DM), the data matrix (DaM) and the erasure counter if possible;
- save state of reduced decoding matrix (DM), the data matrix (DaM) and the erasure counter (EN).

9. The method of one of the preceding claims,
wherein the step of applying the maximum Gaussian elimination comprises at least one of the following steps:
- exchanging two column of the decoding matrix;
- exchanging two rows of the decoding matrix and the corresponding rows in the data matrix;
- adding or subtracting a multiple of a first row of the decoding matrix to a second row of the decoding matrix;
- multiplying a row of the decoding matrix with a scalar.

10. The method of one of the preceding claims,
wherein the steps of selecting a symbol row, exchanging the selected symbol row, recalculating the erasure counter (EN) and performing Gaussian elimination are repeated until a rank of the decoding matrix (DM) is full.

11. The method of one of the preceding claims,
wherein the steps of recovering and reconstructing comprise the steps of:
- performing backward Gaussian elimination;
- computing the recovered columns and the corrupt subsymbols within;
- recovering a stored state of the decoding matrix (DM) and the data matrix;
- re-computing remaining corrupt symbols;
- updating the stored state of the decoding matrix (DM) and the data matrix.

12. The method of claim 11,
wherein the steps of recovering and reconstructing are repeated until all columns are recovered.

13. Apparatus arrangement for decoding block coded symbols, comprising:
- means (102, 103) for demodulating a signal and generating block coded data out of the received signal;
- a data processing element (103), coupled to the means (102) for analyzing the block coded data and designed to determine, whether the block coded data comprise at least a corrupt sub-symbol and designed to mark said subsymbol as erased;
- an correction element (105, 106), coupled to the data processing element (103) and designed to execute the steps of the method of one of the claims 1 to 8 on a plurality of coded symbols comprise having at least one subsymbol marked as erased.
